# EUROPEAN PATENT SPECIFICATION

(11) **EP 4 362 058 B1**
(45) Date of publication and mention of the grant of the patent: **25.09.2024**
(21) Application number: 22204252.5
(22) Date of filing: 27.10.2022
(51) Int. Cl.: H01J 37/32, H05H 1/48

(54) **HOLLOW CATHODE ARC PLASMA DEVICE**
HOHLKATHODEN-LICHTBOGENPLASMAVORRICHTUNG
DISPOSITIF À PLASMA À ARC À CATHODE CREUSE

(43) Date of publication of application: 01.05.2024
(73) Proprietor: Nanofilm Technologies International Limited, Singapore 535226 (SG)
(72) Inventor: ZHAO, Shengfu, Singapore 535226, Singapore (SG); SHI, Xu, Singapore 535226, Singapore (SG); ZHANG, Guangyi, Singapore 535226, Singapore (SG)
(74) Representative: Bajjon, Alexander

(56) References cited:
- EP-A1- 0 621 745
- US-A- 4 977 352
- US-A- 5 397 956
- US-A- 5 539 274

## Description

### Introduction

The present invention relates to an apparatus for generating a plasma from a process gas, and methods of generating a plasma beam.

### Background to the Invention

Plasma sources can be used for large area coating applications including plasma etching, sputtering and reactive coating processes.

Known plasma sources for such applications include capacitively coupled plasma (CCP), inductively coupled plasma (ICP) and electron cyclotron resonance (ECR), all of which ionise the process gas using high energy electrons formed by the plasma source. Other known plasma sources include the end-Hall ion source and linear ion beam source.

There are a number of problems associated with these known plasma sources. The CCP plasma source is unable to produce a sufficiently high-density plasma resulting in lower quality deposition than is desirable for many applications. The ICP plasma source often has high contamination with other gases, therefore resulting in damage to the plasma. Microwave plasma sources, such as ECR, are difficult to scale for large area coating applications.

Filament arc sources, such as the end-Hall ion source and linear ion beam source, often only have a short lifetime since the high temperatures required can cause damage to the filament itself, as well as the substrate.

In addition, many known plasma sources are unable to coat large area substrates. Several solutions have been proposed to address this problem, such as using a 2D axis plate to move the substrate through the coating beam and using an array of point beams so that the entire surface can be coated despite each beam only reaching a small area. A disadvantage of using 2D axis plates is that these are expensive and therefore significantly increase the cost of coating methods. A disadvantage of using an array of point beams is that coatings are often not uniform across the entire surface of the substrate.

Known plasma generation apparatus to provide electron or particle beams are disclosed in EP 0 621 745 A1, US 4 977 352 A, US 5 397 956 A and US 5 539 274 A.

There therefore exists the need for cost-effective plasma sources able to efficiently generate high density plasma with low contamination and with a large scanning area for effective coverage of a substrate.

### Summary of the Invention

The invention provides an apparatus for generating a plasma from a process gas, the apparatus comprising:
a) a power supply
b) a hollow cathode arc tube comprising:
   i) an inert gas inlet
   ii) a cathode tube connected to the power supply and arranged to be negatively biased when the power supply is on
   iii) an anode tube connected to the power supply and arranged to be positively biased when the power supply is on
   iv) an electron beam outlet
c) an ionisation chamber comprising:
   i) an electron beam inlet
   ii) a process gas inlet
   iii) a volume in which ionisation of the process gas can take place to form the plasma
   iv) a plasma outlet
d) a first magnetic field source for confining the plasma inside the ionisation chamber
e) a second magnetic field source for directing and scanning plasma out of the plasma outlet.

It has been found that the apparatus of the invention is able to efficiently generate high density plasma with low contamination. The generated plasma can be used to coat large area substrates efficiently.

The plasma generated by the apparatus of the invention is also referred to as a process gas plasma.

The apparatus of the invention comprises a hollow cathode arc tube, which produces an electron beam that can be used downstream in the apparatus. The hollow cathode arc tube comprises (i) an inert gas inlet, (ii) a cathode tube connected to the power supply and arranged to be negatively biased when the power supply is on, (iii) an anode tube connected to the power supply and arranged to be positively biased when the power supply is on, and (iv) an electron beam outlet.

The inert gas inlet is an aperture in the cathode tube and/or anode tube through which an inert gas can enter the hollow cathode arc tube. The inert gas inlet may further comprise a tube, enabling inert gas to be easily injected (e.g. from outside any casing surrounding the apparatus). The inert gas inlet may comprise a tube split by an insulating connector, for example a ceramic connector. For example, the tube may comprise two sections connected by the insulating connector to prevent the upstream end of the inert gas inlet tube from being charged (by the hollow cathode arc tube). The internal diameter of the inert gas inlet tube may be from 2mm to 6mm, preferably from 3mm to 5mm.

The cathode tube is arranged such that it is negatively biased when the power supply is on, and therefore acts as a cathode when the power supply is on. The cathode tube may therefore be connected to the negative terminal of the power supply.

The cathode tube may be any shape with both an upstream and downstream aperture, for example the cathode tube may be approximately cylindrical in shape, i.e. having a continuous side wall (with a circular cross-section) and two circular end walls, each end wall having an aperture therein. Alternatively, the cathode tube may be tubular in shape, i.e. having a continuous side wall (with a circular cross-section) wherein the open ends of the tube serve as the apertures. In a further embodiment, the cathode tube may be part cylindrical and part tubular, i.e. having a continuous side wall (with a circular cross-section), wherein one end (preferably the upstream end) is open and serves as an aperture, and the second end (preferably the downstream end) having a circular end wall with an aperture therein. Typically, the internal diameter of the cathode tube is typically greater than 1.5mm, for example greater than 2mm and may also be 5mm or less, for example 4mm or less. The outer diameter of the cathode tube may be from 5mm to 8mm.

The cathode tube is typically made of an electrically conductive material, for example a metal. In one embodiment, the cathode tube may be formed from a thermionic electron emitter material (as discussed in further detail below). For example, the cathode tube may be formed from tantalum. Accordingly, the cathode tube may be comprised of 90% or greater (by weight), for example 95% or greater or 98% or greater of the thermionic electron emitter material (e.g. tantalum).

The anode tube is arranged such that it is positively biased when the power supply is on, and therefore acts as an anode when the power supply is on. The anode tube may therefore be connected to the positive terminal of the power supply. The anode tube preferably at least partially surrounds (for example, fully surrounds) the cathode tube, for example the tubes may be approximately concentric.

The anode tube may therefore be any shape that has both an upstream and downstream aperture and allows it to at least partially surround the cathode tube for example, as described above with reference to the cathode tube, the anode tube may be cylindrical, tubular or part cylindrical and part tubular in shape. Typically, the internal diameter of the anode tube is 25mm or greater, for example 30mm or greater and may be 50mm or less, for example 40mm or less.

The anode tube is typically made of an electrically conductive material, for example a metal. As an alternative to a metal, the anode may be formed from graphite, which is also electrically conductive.

The electron beam outlet is an aperture through which an electron beam can exit the hollow cathode arc tube. Typically, the electron beam outlet may be a channel passing through a first aperture in the cathode tube and a second aperture in the anode tube. The diameter of the electron beam outlet channel may be 10mm or greater, for example 15mm or greater and may be 30mm or less, for example 25mm or less.

In use, when the power supply is turned on, a voltage is applied between the cathode and anode tubes causing the cathode tube to be negatively biased and act as a cathode and the anode tube to be positively biased and act as an anode. Inert gas may then be injected into the hollow cathode arc tube via the inert gas inlet. The inert gas passing through the cathode tube initiates glow discharge, which eventually evolves into arc discharge and forms an inert gas plasma. Electrons in the inert gas plasma are accelerated towards the anode, forming an electron beam which passes out of the hollow cathode arc tube via the electron beam outlet.

The hollow cathode arc tube may additionally comprise one or more of (i) a thermionic electron emitter (e.g. the cathode tube may comprise a thermionic emitter), (ii) a coiled heater and/or (iii) an insulator. One or more parts of the hollow cathode arc tube may also be coupled to a cooling system.

A thermionic electron emitter is a material that emits electrons when heated. The presence of a thermionic emitter may increase the density of electrons produced in the hollow cathode tube. The thermionic electron emitter may be positioned inside the cathode tube and may be connected to the cathode tube such that the thermionic electron emitter is also negatively biased when the power supply is on. In an alternative and preferred embodiment, the cathode tube itself may comprise or be formed from a thermionic electron emitter, for example the material of the cathode tube may be a thermionic electron emitter (such as tantalum, tungsten or graphite).

Examples of materials that are thermionic electron emitters include tungsten, graphite, thoriated tungsten, tantalum, barium oxides, strontium oxides, calcium oxides, rare earth metal oxides (e.g. lanthanum oxide, neodymium oxide, gadolinium oxide, cerium oxide, dysoprium oxide, linium oxide, samarium oxide), rare earth metal hexaborides (e.g. lanthanum hexaboride, cerium hexaboride). In preferred embodiments, the thermionic electron emitter is selected from tantalum, tungsten and graphite.

The hollow cathode arc tube may further comprise a heater. The heater may be positioned such that it heats the cathode (e.g. cathode tube) and/or thermionic material (if present), for example the heater may be adjacent to the cathode and/or thermionic material (if present). The heater may be a coiled heater, and in preferred embodiments may be coiled around the cathode tube. When present, the heater may have its own independent power supply or be connected to the same power supply as the cathode tube and anode tube. The heater preferably causes the cathode tube and/or thermionic electron emitter to be heated to a temperature to initiate electron emission from the thermionic electron emitter material.

In a particular embodiment, no heater is required and the hollow cathode arc tube that is made of a thermionic emitter material could be heated directly by the glow discharge, which is initiated by a certain gas flow and the electric field between cathode and anode. Glow discharge is used to increase the temperature of the cathode tube until the thermionic electron emission point, then arc discharge will be initiated.

The hollow cathode arc tube may further comprise an insulator between the cathode tube (the cathode) and the anode tube (the anode), generally in the annular space between the concentric cathode tube and anode tube or at an upstream end of the cathode tube, at a position where it is fixed to the anode tube. The insulator may be an electrical insulator and/or a thermal insulator. The insulator may be made from any suitable electrically insulating and/or thermally insulating material. For example, the insulator may be a ceramic material, such as alumina.

One or more elements of the hollow cathode arc tube may further be connected to a cooling system. In preferred embodiments the anode tube, i.e. the anode, is connected to a cooling system. The cooling system may be any system capable of reducing the temperature of one or more components of the hollow cathode arc tube, for example the cooling system may be a water cooling system. If present, the water cooling system may comprise a series of pipes with an inlet for cool water, an outlet for warm water and a pump for pumping cool water into the inlet. In particularly preferred embodiments a water cooling system is present and the pipes of the water cooling system may run adjacent to the anode.

In preferred embodiments of the invention, the hollow cathode arc tube comprises one or more, or two or more, of a thermionic electron emitter, a coiled heater and an insulator. In some embodiments, the hollow cathode arc tube comprises a thermionic electron emitter, a coiled heater and an insulator.

The power supply provides power to at least the cathode tube and the anode tube. The power supply to each of the cathode and anode tubes may be independently controlled or may be controlled together. In certain embodiments of the invention the same power supply may control further elements of the apparatus, for example the electrostatic lens and, if present, a magnetic field around the hollow cathode arc tube and one or more magnetic fields around the ionisation chamber. However, in alternative embodiments the powered elements may have independent power supplies. The arrangement of the power supplies with regards to each element of the apparatus are considered to be conventional.

The ionisation chamber of the apparatus comprises (i) an electron beam inlet; (ii) a process gas inlet; (iii) a volume in which ionisation of the process gas can take place to form the plasma, and (iv) a plasma outlet. The ionisation chamber may be defined by a casing formed predominantly of stainless steel.

The electron beam inlet is an aperture through which the electron beam (formed upstream in the apparatus) can enter the ionisation chamber. The electron beam inlet is therefore typically positioned on the upstream side of the ionisation chamber, e.g. on the upstream face of the ionisation chamber. Here, the term "upstream" refers to the direction closest to the hollow cathode arc tube. The electron beam inlet typically has a diameter of greater than 25mm, for example greater than 30mm. The diameter is typically less than 50mm and in examples may be from 25mm to 35mm.

The electron beam inlet may be surrounded by an annular anode for accelerating the electron beam through the electron beam inlet. If present, the annular anode is formed from a conductive material and connected to a power supply such that it is arranged to be positively biased when the power supply is on. The anode may be shaped as a ring or disk with an approximately central aperture. The anode may be formed from the same material as the anode tube, e.g. the anode may be made of a metal or of graphite.

The process gas inlet is an aperture through which a process gas can be injected into the ionisation chamber. The process gas inlet is typically positioned on a face of the ionisation chamber other than the face with the electron beam inlet, for example the process gas inlet may be positioned on a face of the ionisation chamber adjacent to that with the electron beam inlet. Preferably, the process gas inlet is orthogonal to the electron beam inlet. The inlet may be fitted with a gas shower ring comprising a plurality of holes (wherein the holes have a diameter of 0.5mm to 1.5mm). The progress gas can then enter the ionisation chamber through the plurality of holes and into the inlet.

The ionisation chamber further comprises a volume in which ionisation of the process gas can take place to form the plasma. The shape of the ionisation chamber is unimportant, however typically the ionisation chamber has a cylindrical shape to facilitate the positioning of other elements around the chamber. When the ionisation chamber is cylindrical in shape, it may have a diameter of from 150mm to 250mm, for example from 180mm to 200mm and may also have a length of from 80mm to 120mm, for example from 90mm to 100mm. Accordingly, the ionisation chamber typically has a volume of from 1400cm³ to 6000cm³, preferably from 2200cm³ to 3200cm³.

The plasma outlet is an aperture through which process gas plasma, formed in the ionisation chamber, can exit the ionisation chamber. The plasma outlet is therefore typically positioned on the downstream side of the ionisation chamber, e.g. on the downstream face of the ionisation chamber. The plasma outlet may therefore be positioned on a side of the ionisation chamber opposite the electron beam inlet and orthogonal to the process gas inlet. The plasma outlet typically has a diameter of from 150mm to 250mm, for example from 180mm to 200mm.

The plasma outlet may be connected to optional additional features of the apparatus. For example, the plasma outlet may be connected to a coating chamber.

The first magnetic field source for confining the plasma within the ionisation chamber (also referred to as the confining magnetic field source) may be positioned concentrically around the ionisation chamber. The confining magnetic field source may act to confine the plasma within the ionisation chamber, and preferably concentrate it towards the centre to the ionisation chamber, to avoid the plasma contacting the walls of the chamber.

The confining magnetic field source may itself be formed of two or more, or four or more, preferably six or more (for example, eight or twelve) magnets, which are preferably permanent magnets. Electromagnets could also be used if the desired magnetic field could be similarly achieved. Preferably the confining magnetic field source is formed from an even number of magnets. It is particularly preferred that, when present, the confining magnetic field source is formed from an even number of alternating polarity magnets. Preferably the alternating polarity magnets are spaced evenly in a circular formation. In particularly preferred embodiments, the confining magnetic field source may be a multi-cusp magnetic field source. A multi-cusp magnetic field source is a magnetic field source that generates a magnetic field with multiple cusps (i.e. multiple points at which the magnetic field changes direction) spaced equally around a circumference. In particularly preferred embodiments, the circle on which the cusps are positioned may be concentric to the ionisation chamber.

Each magnet may provide a magnetic field strength of greater than 4000 Gauss (0.4T), for example greater than 5000 Gauss (0.5T). As a result of the alternating polarity of the magnets spaced equidistantly in a circular arrangement, the magnetic field strength at the centre of the ionisation chamber is typically approximately zero (such as less than 0.05T, for example less than 0.02T).

The magnets may be electromagnets formed from coils of conductive metal wire, preferably copper wire, optionally with a soft magnetic core. In embodiments where the magnets are electromagnets, the electromagnets have a soft magnetic core, wherein the material of the soft magnetic core is preferably selected from iron, iron-silicon alloy, nickel-iron alloy, ceramic materials (e.g. soft ferrites).

The confining magnetic field source may be connected to a power supply to power the electromagnets and preferably can be controlled independently of other powered elements within the apparatus. However, in embodiments where the confining magnetic field source is formed from two or more electromagnets, it is preferred that the multiple electromagnets of the confining magnetic field source are controlled together.

In use, the confining magnetic field source around the ionisation chamber applies a magnetic field within the ionisation chamber, preferably a multi-cusp magnetic field. Without wishing to be bound by theory, it is believed that the magnetic field increases the lifetime of electrons in the ionisation chamber, by preventing electrons being lost via contact with the walls of the chamber, and consequently increases the probability of ionisation of the process gas. The resulting magnetic field is also believed to confine the plasma leading to both an increased density of the process gas plasma and additionally a more uniformly dense process gas plasma.

The second magnetic field source for directing and scanning the plasma out of the plasma outlet (also referred to as the directing magnetic field source) may be positioned at a point on a circumference around the ionisation chamber (i.e. the directing magnetic field source may not be concentric with the ionisation chamber). The directing magnetic field source may act to control and direct the plasma in a desired direction. The second magnetic field source may have the same properties and/or features of the magnetic means for scanning the plasma beam described in earlier patent application no. PCT/GB96/00390, published as WO 96/26532.

The scanning property of the second magnetic field source allows the relative position of the plasma beam exiting the ionisation chamber to be varied within the plasma outlet. The relative position is variable in at least one dimension, but preferably in two dimensions. Accordingly, the second magnetic field source preferably comprises two electromagnets arranged to provide adjustable, orthogonal magnetic fields. This scanning allows the plasma beam to be directed to a large 2D area. For example, the scanning plasma beam allows a relatively large surface of a substrate to be coated or etched without the need to move the substrate.

The second magnetic field source may be any suitable magnetic field source with an adjustable magnetic field strength. In preferred embodiments, the directing magnetic field source is an electromagnet, for example a C-shaped scanning electromagnet comprising a C-shaped soft magnetic core with two open poles and a conductive wire wound around the centre of the C-shaped soft magnetic core, acting as a solenoid. The conductive wire is connected to a power supply and therefore when the power supply is on, a magnetic field may be generated between the two poles of the C-shaped scanning electromagnet.

Preferably, where the directing magnetic field source is formed from a soft magnetic core surrounded by a conductive wire, the soft magnetic core may be formed from any soft magnetic material, for example iron, iron-silicon alloy, nickel-iron alloy, ceramic materials (e.g. soft ferrites). The conductive wire is preferably a copper wire.

In use, the directing magnetic field source around the ionisation chamber applies an adjustable magnetic field within the ionisation chamber. The magnetic field can be adjusted by varying the current supplied to the conductive wire by the power supply, therefore enabling manipulation of the process gas plasma. The adjustable magnetic field allows the process gas plasma to be moved horizontally and/or vertically in a plane orthogonal to the original plasma trajectory. The deposition rates in different areas of the substrate may be monitored and the relevant data fed back to the scanning control means. The desired rate of deposition could be controlled in each deposition area. Therefore, the second magnetic field source enables efficient and uniform coating of a 2-dimensional large area substrate.

In certain embodiments, the directing magnetic field source may comprise two electromagnets, e.g. two C-shaped scanning electromagnets. In embodiments where the directing magnetic field source comprises two electromagnets, the electromagnets may be positioned such that they complement each other, for example the two electromagnets may both be positioned on a circumference around the ionisation chamber, preferably the circumference on which the electromagnets are positioned is concentric to the ionisation chamber. In preferred embodiments, the angle between the two electromagnets on a circumference may be between 10 degrees and 180 degrees, preferably between 30 degrees and 150 degrees, most preferably between 60 degrees and 120 degrees, for example approximately 90 degrees.

In embodiments where the directing magnetic field source comprises two electromagnets, the two electromagnets may work together to manipulate the process gas plasma in both horizontal and vertical directions. The electromagnets together may therefore assist in producing a high-density plasma and a uniform and dense coating on a substrate.

In preferred embodiments, the circles on which each of the confining and directing magnetic field sources are positioned are concentric to each other, and preferably also to the ionisation chamber.

In preferred embodiments of the invention, the apparatus comprises a magnetic field source for increasing the density of the electron beam inside the hollow cathode arc tube and/or an electrostatic lens for focussing the electron beam. In particularly preferred embodiments, the apparatus comprises a magnetic field source for increasing the density of the electron beam inside the hollow cathode arc tube and an electrostatic lens for focussing the electron beam.

The apparatus according to the invention may comprise a magnetic field source for increasing the density of the electron beam inside the cathode tube (also referred to as a density increasing magnetic field source). In preferred embodiments the density increasing magnetic field source may be positioned concentrically around the cathode tube. In particularly preferred embodiments the density increasing magnetic field source may be a solenoid, formed from conductive wire (preferably copper wire) coiled concentrically around the cathode tube. The magnetic field source typically provides a magnetic field strength of greater than 100 Gauss (0.1T) for example greater than 200 Gauss (0.2T) at the centre of the cathode tube. Here, the centre of the cathode tube refers to the longitudinal axis of the tube.

In use, a density increasing magnetic field source applies a magnetic field within the hollow cathode arc tube. In preferred embodiments, for example when the magnetic field source is a solenoid, the applied magnetic field is an axial magnetic field with respect to the axes of the anode and cathode tubes. Typically, the direction of flow of current through the solenoid is such that the upstream end of the solenoid is the north pole, and the downstream end is the south pole. Without wishing to be bound by theory, it is believed that the magnetic field causes electrons to move in a helical trajectory, increasing the lifetime of each electron and therefore increasing the probability of ionisation of the inert gas. In turn, resulting in a lower flow rate requirement for the inert gas and increased plasma density and consequently increased electron beam density.

The apparatus according to the invention may additionally comprise an electrostatic lens for focussing the electron beam. The electrostatic lens is generally positioned downstream of the hollow cathode arc tube and upstream of the ionisation chamber. An electrostatic lens is a lens that focusses electrons and can guide them from one area to another. Accordingly, the electrostatic lens focusses the electron beam generated by the hollow cathode arc tube before it enters the ionisation chamber. The electrostatic lens of the invention (if present) may be any known electrostatic lens, for example a cylinder lens, an Einzel lens, a quadrupole lens or a magnetic lens. Preferably, where present, the electrostatic lens can focus the electron beam without changing the energy of the electron beam. In preferred embodiments, an electrostatic lens is present in the apparatus of the invention. In particularly preferred embodiments, the apparatus comprises an Einzel lens comprising alternating disks of electrically conductive and electrically insulating material.

In such particularly preferred embodiments, the alternating disks form an approximately annular shape, with an approximately central aperture which may have an interior diameter of from 40mm to 70mm, preferably from 50mm to 60mm. The thickness of each alternating disk is typically from 2mm to 10mm, preferably from 3mm to 7mm, more preferably from 4mm to 6mm.

In preferred embodiments where the electrostatic lens is formed from alternating disks of electrically conductive and electrically insulating material, typically the outer disks (i.e. those at either end of the electrostatic lens) are electrically insulating disks, whilst the electrically conducting disks are typically internal to the electrostatic lens. In such preferred embodiments, there are typically between 2 and 10 electrically insulating disks and between 1 and 9 electrically conducting disks, preferably between 3 and 8 electrically insulating disks and between 2 and 7 electrically conducting disks, most preferably between 4 and 6 electrically insulating disks and between 3 and 5 electrically conducting disks.

The electrically conducing material of the electrostatic lens may be a conductive metal, preferably one that is stable at high temperatures (for example, stable at temperatures above 500°C). As an example, the electrically conducting material may be steel (for example, stainless steel) or a nickel-chromium-based alloy. The electrically insulating material of the electrostatic lens may be a ceramic material, such as alumina.

The conductive disks of the electrostatic lens may be connected to a power supply such that they are positively biased when the power supply is on. The conductive disks may each be provided with an independent power supply, or alternatively can all be supplied by the same power supply. In preferred embodiments, all conductive disks are biased to the same voltage, e.g. a voltage of from 10kV to 100kV, from 15kV to 70kV, from 20kV to 50kV.

In use, the electrostatic lens collimates and focuses the electron beam from the hollow cathode arc tube towards the ionisation chamber. The electrostatic lens increases electron beam density, therefore resulting in a greater density of process gas plasma in the ionisation chamber.

In preferred embodiments, the invention may therefore provide an apparatus for generating a plasma from a process gas, the apparatus comprising:
a) a power supply
b) a hollow cathode arc tube comprising:
   i) an inert gas inlet
   ii) a cathode tube connected to the power supply and arranged to be negatively biased when the power supply is on
   iii) an anode tube connected to the power supply and arranged to be positively biased when the power supply is on
   iv) an electron beam outlet
c) a magnetic field source for increasing the density of the electron beam inside the hollow cathode arc tube
d) an ionisation chamber comprising:
   i) an electron beam inlet;
   ii) a process gas inlet
   iii) a volume in which ionisation of the process gas can take place to form the plasma
   iv) a plasma outlet
e) a first magnetic field source for confining the plasma inside the ionisation chamber
f) a second magnetic field source for directing and scanning plasma out of the plasma outlet.

In further preferred embodiments, the apparatus comprises an electrostatic lens for focussing the electron beam.

In preferred embodiments, the invention may therefore provide an apparatus for generating a plasma from a process gas, the apparatus comprising:
a) a power supply
b) a hollow cathode arc tube comprising:
   i) an inert gas inlet
   ii) a cathode tube connected to the power supply and arranged to be negatively biased when the power supply is on
   iii) an anode tube connected to the power supply and arranged to be positively biased when the power supply is on
   iv) an electron beam outlet
c) an electrostatic lens for focussing the electron beam;
d) an ionisation chamber comprising:
   i) an electron beam inlet;
   ii) a process gas inlet
   iii) a volume in which ionisation of the process gas can take place to form the plasma
   iv) a plasma outlet
e) a first magnetic field source for confining the plasma inside the ionisation chamber
f) a second magnetic field source for directing and scanning plasma out of the plasma outlet.

In particularly preferred embodiments, the invention provides an apparatus for generating a plasma from a process gas, the apparatus comprising:
a) a power supply
b) a hollow cathode arc tube comprising:
   i) an inert gas inlet
   ii) a cathode tube connected to the power supply and arranged to be negatively biased when the power supply is on
   iii) an anode tube connected to the power supply and arranged to be positively biased when the power supply is on
   iv) an electron beam outlet
c) a magnetic field source for increasing the density of the electron beam inside the hollow cathode arc tube
d) an electrostatic lens for focussing the electron beam;
e) an ionisation chamber comprising:
   i) an electron beam inlet (optionally comprising an annular anode for accelerating the electron beam)
   ii) a process gas inlet
   iii) a volume in which ionisation of the process gas can take place to form the plasma
   iv) a plasma outlet
f) a first magnetic field source for confining the plasma inside the ionisation chamber
g) a second magnetic field source for directing and scanning plasma out of the plasma outlet.

The invention further provides a method of generating a plasma beam comprising:
i) generating an inert gas plasma containing electrons and inert gas ions via arc discharge;
ii) accelerating and focussing the electron beam into an ionisation chamber;
iii) injecting a process gas into the ionisation chamber such that it is ionised by the electron beam to form a process gas plasma in the ionisation chamber;
iv) focussing by a magnetic field and optionally scanning the process gas plasma using one or more electromagnets to form a plasma beam.

To initiate the generation of an inert gas plasma in step (i), an inert gas input is required. The inert gas may be selected from one of argon, helium neon. Preferably, the inert gas is argon.

The step of initiating the generation of an inert gas plasma may itself be a two step process. Initially, an inert gas is input with a first continuous flow rate whilst a first power supply provides a first current to a cathode. Once glow discharge has begun, the flow rate of the inert gas is reduced to a second continuous flow rate and the current provided to the cathode is increased to a higher, second current resulting in arc discharge.

The first input flow rate of the inert gas is typically from 150sccm to 350sccm, preferably from 200sccm to 300sccm. The flow rate is typically then reduced to a second flow rate of from 10sccm to 60scm, preferably from 20 to 50sccm (e.g. approximately 30sccm).

The first current supplied is typically from 0.1A to 4A, preferably from 0.5A to 3A, more preferably from 0.5A to 2A. The current is typically then increased to a second current of from 1A to 5A, preferably from 1.5A to 4A, e.g. approximately 3A. Preferably the second current is higher than the first current. It is noted that in order to maintain an approximately constant current, as the cathode tube starts to emit hot electrons, it may be necessary to adjust (e.g. to reduce) the voltage of the power supply as the cathode tube heats up during use (since as the temperature of the hollow cathode tube increases, the resistivity of the cathode also increases). Typically it is necessary to reduce the voltage from approximately 300V to 4000V initially to approximately 50V to 100V, as the cathode heats up.

In step (iii), the process gas may be selected depending on the desired application of the resulting plasma beam. The process gas plasma may be selected from any of argon, oxygen, nitrogen, and hydrocarbon gases (e.g. methane, ethane, propane, butane, ethylene, propylene, butylene, acetylene). Where the process gas is a hydrocarbon gas, it is preferably acetylene. In embodiments where the resulting plasma beam is used for plasma etching, the process gas is preferably argon. In embodiments where the resulting plasma beam is used for sputtering, the process gas is preferably selected from argon, oxygen or nitrogen. In embodiments where the resulting plasma beam is used for reactive coating process, the process gas is preferably selected from oxygen, nitrogen or a hydrocarbon gas. In embodiments where the resulting plasma beam is used to coat a substrate with diamond-like carbon (DLC), the process gas is preferably a hydrocarbon gas, e.g. acetylene.

The input flow rate of the process gas is typically from 5sccm to 700sccm, preferably from 10sccm to 500sccm.

The method according to the invention is typically carried out using the apparatus of the invention as described above. As such, the step of generating an inert gas plasma is typically carried out in the hollow cathode arc tube of the invention. The step of accelerating and focussing the electron beam is typically the result of a magnetic field generated by an electrostatic lens, optionally in combination with an annular anode comprised within the electron beam inlet of the ionisation chamber.

The method according to the invention may additionally comprise the step of enhancing the inert gas plasma density using a magnetic field. The magnetic field may be produced by a magnetic field source around a hollow cathode arc tube, as described above. The magnetic field may be generated by a solenoid.

The method of the invention may independently involve one or more additional steps of confining and/or directing the plasma beam.

Confining the plasma beam refers to a step of ensuring the plasma beam is retained within the ionisation chamber without contacting the walls of the ionisation chamber. The plasma beam may be confined by a confining magnetic field source (e.g. a multi-cusp magnetic field source), as described above. The confining magnetic field source, may additionally act to enhance the density of the plasma beam, as described above.

Directing the plasma beam refers to a step of manipulating the plasma beam to travel in a desired direction. The desired direction of travel for the plasma beam may involve directing the plasma beam through the plasma outlet, directing the plasma beam towards a substrate and/or directing the plasma beam towards a target. The step of directing the plasma beam may preferably comprise scanning the plasma beam across the surface of a substrate in order to evenly coat and/or etch the substrate. The plasma beam may be directed by a directing magnetic field source (for example one or more C-shaped scanning electromagnets), as described above. The plasma beam may be directed by varying the magnetic field strength of the directing magnetic field source, for example by varying the current supplied to the one or more electromagnets.

Step (ii) of the method may additionally involve collimating the electron beam. Collimation is the process of aligning the path of all electrons in the beam such that they are all travelling along substantially parallel paths. Collimation of the electron beam may be achieved using an electrostatic lens as described above, e.g. an Einzel lens.

### Brief Description of the Drawings

The present invention is now described in more specific detail with reference to the accompanying drawings in which:
Fig. 1 shows a schematic representation of an apparatus for generating plasma according to the invention.
Fig. 2 shows a schematic representation of a hollow cathode arc tube for use in the apparatus of the invention.
Fig. 3 shows a schematic representation of an alternative cathode arc tube for use in the apparatus of the invention.

### Detailed Description of the Invention

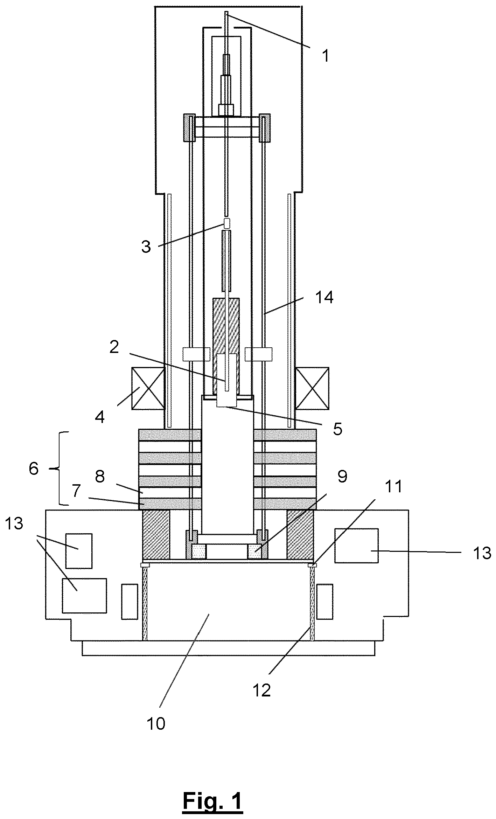

Fig. 1 shows a diagram of an apparatus according to the invention. The apparatus has an inert gas inlet 1 having a diameter of 4mm connected via an insulating ceramic gas flow connector 3 to a hollow cathode tube 2. The hollow cathode tube 2 is a conventional plasma generating hollow cathode tube and has a refractory metal tube (i.e. cathode) constructed of tantalum surrounded by a coiled heater (not shown) and embedded in a keeper (i.e. electron gun anode) 5. The refractory metal cathode tube has an outer diameter of 6mm and an inner diameter of 2mm or 4mm and is formed from tantalum. The keeper anode tube 5 has an internal diameter of 32.5mm and is made from graphite. The refractory metal tube and keeper are electrically insulated from each other with alumina (not shown). Both the refractory metal tube and keeper have a small outlet downstream of the inert gas inlet (not shown). The hollow cathode tube has two separate power supplies (not shown), both connected to the keeper 5 and cathode which positively bias the anode and negatively bias the cathode, whilst also powering the coiled heater. The first supply is a starter power supply (10kW SPT DC power supply) and the second supply is a keeper power supply (100V/200A DC power supply). The hollow cathode tube 2 is further surrounded by a solenoid 4 with an independent power supply (not shown). The solenoid power supply is a 160V/25A DC power supply.

Downstream of the hollow cathode tube 2 is an electrostatic lens 6 formed of alternating rings of insulating alumina 7 and stainless steel conducting rings 8. The electrostatic lens again has an independent power supply (not shown). The rings have a thickness of 5mm, an external diameter of 155mm and an internal diameter of electrostatic lens is 55mm.

Further downstream is a positively charged graphite annular anode 9 with a central aperture of a diameter of 32.5mm. The anode 9 is thermally coupled to a water cooling system 14.

The anode 9 is upstream of an ionisation chamber 10, which in turn is surrounded by a multi-cusp magnet 12 and C-shaped scanning electromagnets 13. The ionisation chamber 10 itself is defined by a stainless steel casing with an inlet 11 for a process gas. The ionisation chamber is cylindrical in shape with a diameter of 190mm and a length of 94.5mm. The multi-cusp magnet 12 is formed of a ring of 8 radially aligned magnets with alternating polarity. The two scanning electromagnets 13 are formed from a C-shaped soft magnetic core with two open poles, surrounded by a conductive wire, and therefore acting as a solenoid.

In use, an inert gas is injected via the inert gas inlet 1 at a rate of 10sccm to 50 sccm and passes through to the hollow cathode tube 2, via a ceramic gas flow connector 3. The ceramic connector 3 acts as a potential divider between the negatively biased hollow cathode 2 and the earthed inert gas inlet 1. The starter power supply (not shown) is turned on and glow discharge occurs in the negatively charged hollow cathode 2. Over time, the glow discharge evolves into arc discharge, the starter power supply is turned off, the keeper power supply (not shown) is initiated and an inert gas plasma is formed.

A solenoid 4 coaxially surrounds the hollow cathode tube 2 is charged by its power supply to ~20A and leads to an axial magnetic field within the hollow cathode tube. The axial magnetic field causes electrons (formed via arc discharge) to move in a helical trajectory, increasing the lifetime of each electron and increasing the probability of ionisation of the inert gas, in turn increasing the inert gas plasma density whilst allowing a lower inert gas flow to be used.

Electrons from the inert gas plasma are accelerated through a first anode 5 into an electrostatic lens 6. The electrostatic lens 6 collimates the electron beam and focusses it through a second anode 9 into an ionisation chamber 10.

A process gas is injected into the ionisation chamber 10 via the process gas inlet 11 at a flow rate of from 10sccm to 500sccm (depending on the intended use of the process gas plasma). The electron beam ionises the process gas forming a process gas plasma. The ionisation chamber is surrounded by a multi-cusp magnet 12 and C-shaped scanning electromagnets 13. The multi-cusp magnet 12 forms a multi-cusp magnetic field within the ionisation chamber 10, which reflects electrons back into the plasma, increasing the lifetime of the ionising electrons leading to increased density of the process gas plasma whilst also confining and stabilising the process gas plasma.

The apparatus shown in Fig. 1 shows two C-shaped electromagnets. The magnetic field produced by the C-shaped scanning electromagnets 13 can be controlled by controlling the flow of current through the conductive wire. As such, the C-shaped electromagnets can be used together to control and direct the plasma as required. For example, the C-shaped scanning electromagnets can be used to direct the process gas plasma through a plasma outlet (not shown) and onto a substrate for plasma etching.

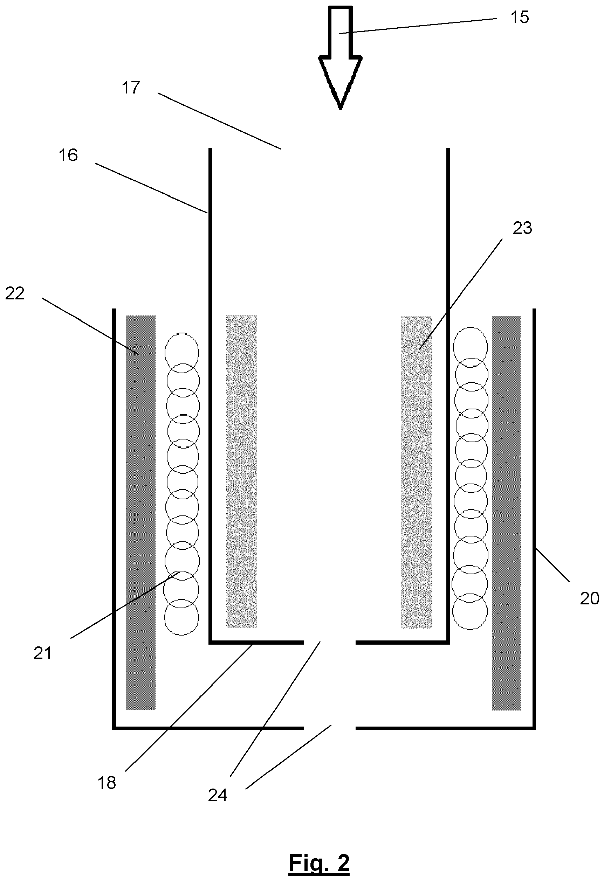

Fig. 2 shows a diagram of a hollow cathode arc tube for use in the apparatus of the invention. The hollow cathode arc tube has a cathode tube 16 that is part tubular and part cylindrical, with a continuous side wall with a circular cross-section, the upstream end 17 serving as an aperture, and the downstream end 18 having a circular end wall with an aperture therein. The hollow cathode tube also has an anode tube 20 that is part tubular and part cylindrical in the same way as the cathode tube 16.

Between the cathode tube 16 and anode tube 20, i.e. in the annular space between the cathode and anode tubes, is a coiled heater 21 formed from a coil of stainless steel wire wound around the cathode tube. There may also be an alumina insulator 22 between the cathode tube 16 and anode tube 20.

The hollow cathode arc tube additionally has an electron beam outlet 24, formed from apertures in the downstream end walls of the anode tube and cathode tube. The electron beam outlet 24, may be considered to be a channel between the aperture in the downstream end wall of the anode tube and the downstream end wall of the cathode tube.

In use, inert gas is injected into the hollow cathode arc tube from the upstream end, in the direction indicated by arrow 15. Inside the hollow cathode arc tube, the coiled heater 21 causes the tantalum thermionic electron emitter 23 to heat up and emit electrons, leading initially to glow discharge. Over time arc discharge replaces the initial glow discharge, and an inert gas plasma is formed inside the cathode tube 16. The insulator 22 significantly reduces the heating effect of the coiled heater on the anode tube 20, preventing the anode tube from overheating in use. Electrons in the inert gas plasma, are accelerated towards the positively charged anode tube 20, and exit the hollow cathode arc tube via the electron beam outlet 24.

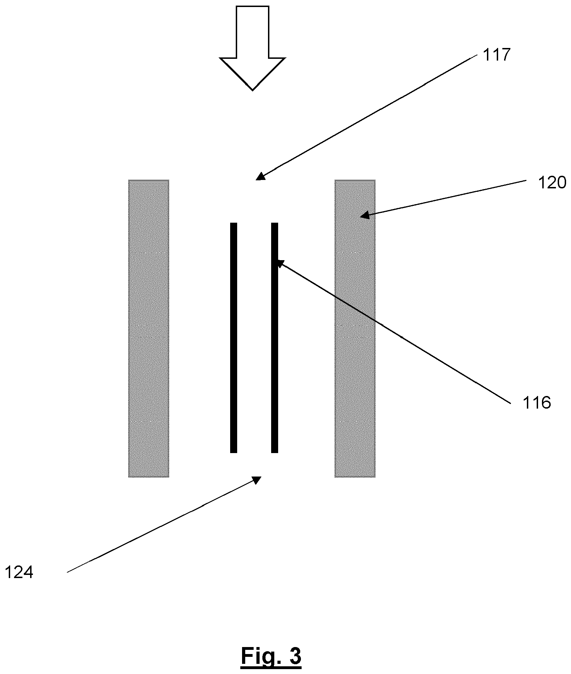

Fig. 3 shows a diagram of an alternative hollow cathode arc tube for use in the apparatus of the invention. The hollow cathode arc tube has a cathode tube 116 that is tubular, with a circular cross-section, the downstream end being open and the upstream end also open with an aperture 117 therein, which serves as an inert gas inlet. The hollow cathode also has a tubular anode tube 120 outside the cathode tube 116. The cathode tube is formed from tantalum and serves as the thermionic emitter material.

In this arrangement, no heater is present and the glow discharge of the inert gas causes a sufficient increase in temperature to cause thermionic emission from the tantalum cathode tube.

The hollow cathode arc tube additionally has an electron beam outlet 124, formed from apertures/openings in the downstream ends of the anode tube and cathode tube.

Either the hollow cathode arc tube shown in Fig. 2 or Fig. 3 can be used in the apparatus of the invention.

### Examples

### Example 1 - Operating apparatus of the invention

An apparatus was manufactured according to Fig. 1, as described above, with a hollow cathode arc tube as described above with reference to Fig. 3. The apparatus was operated as set out below.

### Start Up:

1. The keeper power supply to both the anode and cathode of the hollow cathode arc tube was energised and set to provide a voltage of 0V and a current of 0V.
2. The hollow cathode gas flow was started at approximately 250sccm with Argon gas.
3. The starter power supply to both the anode and cathode of the hollow cathode arc tube was energised and set to provide a voltage of 0V and a current of 0V.
4. The starter power supply current was increased from 0A to 2.0A and time was then left until the voltage suddenly dropped from 300V to 80V and stabilised.
5. The hollow cathode gas flow rate was reduced to 30sccm.
6. The hollow cathode was switched from using the starter power supply to the keeper power supply.
6. The keeper power supply current was increased from 0A to 3A, and the starter power supply was turned off.

It is important for the starter power supply to start from 0V, 0A in order to minimize the arcing problems from the tantalum tube during the initial glow discharge period. The keeper power supply will always be set at a certain output current, for example 20A in constant current mode. Before the cathode and anode are switched from the starter to keeper supply, the keeper will show zero voltage or current as it is not connected. Once keeper supply has been connected, it will typically provide a current of from 5A to 30A (for example, 20A) with a voltage between 20V to 80V.

### Running:

1. The acetylene process gas was injected into the ionisation chamber and a bias was applied to the metal substrate which was held in a rotating holder.
2. The solenoid power supply was turned on and the current was increased to 20A.
3. Power supplies to the electrostatic lens and anode between the electrostatic lens and ionisation chamber were started at approximately 5A, 4000V and 30A, 50V respectively.
4. Power supplies to the C-shaped scanning electromagnet were initiated and the current is set to vary in the range of -7A to 7A.
5. The current to the keeper power supply was increased to approximately 20A.
6. The current supplied to the C-shaped scanning electromagnet was varied as required to direct the plasma beam and coat the substrate.

### Turn to Idle Mode:

1. The process gas inlet was closed.
2. The current to the solenoid coil was reduced to 0A.
3. The keeper power supply current was reduced to 2A

A coated metal substrate was produced with a uniform and dense coating of diamond-like carbon.

### Example 2 - Testing solenoid

The solenoid was tested using the apparatus of example 1. A window in the apparatus casing allowed a view of the downstream side of the inlet to the ionisation chamber (i.e. a view of the inlet to the ionisation chamber from inside the ionisation chamber).

Firstly, all "start up" steps of the method of example 1 were carried out. The multi-cusp magnet comprises permanent magnets. Initially, the solenoid power supply was turned off. The inlet glowed, demonstrating that self-sustaining arc discharge was occurring. However, there was no defined beam of electrons entering the chamber.

The solenoid power supply was then turned on and increased to 20A. No other parameters or power supplies were adjusted. After allowing some equilibration time, the inlet of the ionisation chamber was viewed again. A defined glowing beam of electrons could be seen entering the ionisation chamber.

It was therefore clear that the solenoid led to increased plasma density and collimation.

### Example 3 - Testing multi-cusp magnet

The multi-cusp magnet was tested using the apparatus of example 1 and using the same window to view the downstream side of the inlet to the ionisation chamber as was used in example 2.

Firstly, all "start up" steps of the method of example 1 were carried out. The solenoid power supply was then turned on and increased to 20A. Initially the multi-cusp magnet was not present. A glowing beam of electrons could be seen, however this spread outwards as it came further into the ionisation chamber (i.e. the diameter of the electron beam increased as it travelled further into the ionisation chamber).

The multi-cusp magnet was then added. After allowing some equilibration time, the inlet of the ionisation chamber was viewed again. Again a glowing electron beam could be seen, however this no longer visible spread out as it entered the ionisation chamber. Instead, the electron beam had an approximately uniform diameter as it travelled into the ionisation chamber.

## Claims

1. An apparatus for generating a plasma from a process gas, the apparatus comprising:
a) a power supply
b) a hollow cathode arc tube (2) comprising:
i) an inert gas inlet (1; 117)
ii) a cathode tube (16; 116) connected to the power supply and arranged to be negatively biased when the power supply is on
iii) an anode tube (5; 120) connected to the power supply and arranged to be positively biased when the power supply is on
iv) an electron beam outlet (24; 124)
c) an ionisation chamber (10) comprising:
i) an electron beam inlet
ii) a process gas inlet (11)
iii) a volume in which ionisation of the process gas can take place to form the plasma
iv) a plasma outlet
d) a first magnetic field source (12) for confining the plasma inside the ionisation chamber
e) a second magnetic field source (13) for directing and scanning plasma out of the plasma outlet.

2. An apparatus according to claim 1 further comprising a magnetic field source (4), such as a solenoid coil, surrounding the hollow cathode arc tube (2).

3. An apparatus according to claim 1 or claim 2 further comprising an electrostatic lens (6) for focussing the electron beam.

4. An apparatus according to claim 3, wherein the electrostatic lens (6) comprises alternating rings (7, 8) of an electrically insulating material and an electrically conducting material.

5. An apparatus according to any one of claims 1 to 4 wherein the first magnetic field source (12) for confining the plasma inside the ionisation chamber comprises 4 or more magnetic field sources of alternating polarities.

6. An apparatus according to any one of claims 1 to 5, wherein the second magnetic field source (13) for directing and scanning plasma out of the plasma outlet has an adjustable magnetic field.

7. An apparatus according to any of claims 1 to 6, wherein the second magnetic field source (13) for directing and scanning plasma out of the plasma outlet comprises two electromagnets.

8. An apparatus according to any one of claims 1 to 7 wherein the electron beam inlet comprises an annular anode (9) for accelerating the electron beam through the electron beam inlet.

9. A method of generating a plasma beam comprising:
i) generating an inert gas plasma containing electrons and inert gas ions via arc discharge;
ii) accelerating and focussing the electron beam into an ionisation chamber;
iii) injecting a process gas into the ionisation chamber such that it is ionised by the electron beam to form a process gas plasma in the ionisation chamber;
iv) focussing by a magnetic field and scanning the process gas plasma using one or more electromagnets to form a plasma beam.

10. A method according to claim 9, wherein the method additionally involves enhancing the inert gas plasma density using a magnetic field (e.g. generated by a solenoid).

11. A method according to either claim 9 or 10, wherein the method additionally involves enhancing the process gas plasma density using a multi-cusp magnetic field.

12. A method according to any of claims 9 to 11, wherein in step (ii) the electron beam is additionally collimated by an electrostatic lens.

13. A method according to claim 9 wherein the inert gas is argon.

14. A method according to claim 9 or 10 wherein the process gas is selected from nitrogen, oxygen and hydrocarbon gases.

15. A method of generating a plasma beam according to any of claims 9 to 14 using an apparatus according to any of claims 1 to 8.

## Patentansprüche

1. Vorrichtung zum Erzeugen eines Plasmas aus einem Prozessgas, wobei die Vorrichtung Folgendes umfasst:
a) eine Stromversorgung
b) eine Hohlkathoden-Lichtbogenröhre (2), umfassend:
i) einen Inertgaseinlass (1; 117)
ii) eine Kathodenröhre (16; 116), die mit der Stromversorgung verbunden und angeordnet ist, um negativ vorgespannt zu sein, wenn die Stromversorgung ein ist
iii) eine Anodenröhre (5; 120), die mit der Stromversorgung verbunden und angeordnet ist, um positiv vorgespannt zu sein, wenn die Stromversorgung ein ist
iv) einen Elektronenstrahlauslass (24; 124)
c) eine Ionisationskammer (10), umfassend:
i) einen Elektronenstrahleinlass
ii) einen Prozessgaseinlass (11)
iii) ein Volumen, in dem Ionisierung des Prozessgases stattfinden kann, um das Plasma zu bilden
iv) einen Plasmaauslass
d) eine erste Magnetfeldquelle (12) zum Beschränken des Plasmas innerhalb der Ionisationskammer
e) eine zweite Magnetfeldquelle (13) zum Lenken und Abtasten von Plasma aus dem Plasmaauslass.

2. Vorrichtung nach Anspruch 1, ferner umfassend eine Magnetfeldquelle (4) wie eine Solenoidspule, welche die Hohlkathoden-Lichtbogenröhre (2) umgibt.

3. Vorrichtung nach Anspruch 1 oder Anspruch 2, ferner umfassend eine elektrostatische Linse (6) zum Fokussieren des Elektronenstrahls.

4. Vorrichtung nach Anspruch 3, wobei die elektrostatische Linse (6) abwechselnde Ringe (7, 8) aus einem elektrisch isolierenden Material und einem elektrisch leitenden Material umfasst.

5. Vorrichtung nach einem der Ansprüche 1 bis 4, wobei die erste Magnetfeldquelle (12) zum Beschränkendes Plasmas innerhalb der Ionisationskammer 4 oder mehr Magnetfeldquellen mit abwechselnden Polaritäten umfasst.

6. Vorrichtung nach einem der Ansprüche 1 bis 5, wobei die zweite Magnetfeldquelle (13) zum Lenken und Abtasten von Plasma aus dem Plasmaauslass ein einstellbares Magnetfeld aufweist.

7. Vorrichtung nach einem der Ansprüche 1 bis 6, wobei die zweite Magnetfeldquelle (13) zum Lenken und Abtasten von Plasma aus dem Plasmaauslass zwei Elektromagneten umfasst.

8. Vorrichtung nach einem der Ansprüche 1 bis 7, wobei der Elektronenstrahleinlass eine ringförmige Anode (9) zum Beschleunigen des Elektronenstrahls durch den Elektronenstrahleinlass umfasst.

9. Verfahren zum Erzeugen eines Plasmastrahls, umfassend:
i) Erzeugen eines Inertgasplasmas, das Elektronen und Inertgasionen enthält, über Lichtbogenentladung;
ii) Beschleunigen und Fokussieren des Elektronenstrahls in eine Ionisationskammer;
iii) Einspritzen eines Prozessgases in die Ionisationskammer, sodass es durch den Elektronenstrahl ionisiert wird, um ein Prozessgasplasma in der Ionisationskammer zu bilden;
iv) Fokussieren durch ein Magnetfeld und Abtasten des Prozessgasplasmas unter Verwendung von einem oder mehreren Elektromagneten, um einen Plasmastrahl zu bilden.

10. Verfahren nach Anspruch 9, wobei das Verfahren zusätzlich Erhöhen der Inertgasplasmadichte unter Verwendung eines Magnetfeldes (z. B. erzeugt durch ein Solenoid) involviert.

11. Verfahren nach Anspruch 9 oder 10, wobei das Verfahren zusätzlich Erhöhen der Prozessgasplasmadichte unter Verwendung eines Multi-Cusp-Magnetfeldes involviert.

12. Verfahren nach einem der Ansprüche 9 bis 11, wobei in Schritt (ii) der Elektronenstrahl zusätzlich durch eine elektrostatische Linse kollimiert wird.

13. Verfahren nach Anspruch 9, wobei das Inertgas Argon ist.

14. Verfahren nach Anspruch 9 oder 10, wobei das Prozessgas aus Stickstoff-, Sauerstoff- und Kohlenwasserstoffgasen ausgewählt ist.

15. Verfahren zum Erzeugen eines Plasmastrahls nach einem der Ansprüche 9 bis 14 unter Verwendung einer Vorrichtung nach einem der Ansprüche 1 bis 8.

## Revendications

1. Appareil de génération d'un plasma à partir d'un gaz de traitement, l'appareil comprenant :
a) une alimentation électrique
b) un tube à arc à cathode creuse (2) comprenant :
i) une entrée de gaz inerte (1 ; 117)
ii) un tube cathodique (16 ; 116) relié à l'alimentation électrique et agencé pour être polarisé négativement lorsque l'alimentation électrique est allumée
iii) un tube anodique (5 ; 120) relié à l'alimentation électrique et agencé pour être polarisé positivement lorsque l'alimentation électrique est allumée
iv) une sortie de faisceau électronique (24 ; 124)
c) une chambre d'ionisation (10) comprenant :
i) une entrée de faisceau électronique
ii) une entrée de gaz de traitement (11)
iii) un volume dans lequel l'ionisation du gaz de traitement peut avoir lieu pour former le plasma
iv) une sortie de plasma
d) une première source de champ magnétique (12) pour confiner le plasma à l'intérieur de la chambre d'ionisation
e) une seconde source de champ magnétique (13) pour diriger et balayer le plasma hors de la sortie de plasma.

2. Appareil selon la revendication 1, comprenant en outre une source de champ magnétique (4), telle qu'une bobine solénoïde, entourant le tube à arc à cathode creuse (2).

3. Appareil selon la revendication 1 ou la revendication 2, comprenant en outre une lentille électrostatique (6) pour focaliser le faisceau électronique.

4. Appareil selon la revendication 3, dans lequel la lentille électrostatique (6) comprend des anneaux alternés (7, 8) d'un matériau électriquement isolant et d'un matériau électriquement conducteur.

5. Appareil selon l'une quelconque des revendications 1 à 4, dans lequel la première source de champ magnétique (12) pour confiner le plasma à l'intérieur de la chambre d'ionisation comprend 4 sources de champ magnétique ou plus de polarités alternées.

6. Appareil selon l'une quelconque des revendications 1 à 5, dans lequel la seconde source de champ magnétique (13) pour diriger et balayer le plasma hors de la sortie de plasma comporte un champ magnétique réglable.

7. Appareil selon l'une quelconque des revendications 1 à 6, dans lequel la seconde source de champ magnétique (13) pour diriger et balayer le plasma hors de la sortie de plasma comprend deux électro-aimants.

8. Appareil selon l'une quelconque des revendications 1 à 7, dans lequel l'entrée du faisceau électronique comprend une anode annulaire (9) pour accélérer le faisceau électronique à travers l'entrée du faisceau électronique.

9. Procédé de génération d'un faisceau de plasma comprenant :
i) la génération d'un plasma de gaz inerte contenant des électrons et des ions de gaz inerte via une décharge en arc ;
ii) l'accélération et la focalisation du faisceau électronique dans une chambre d'ionisation ;
iii) l'injection d'un gaz de traitement dans la chambre d'ionisation de telle sorte qu'il soit ionisé par le faisceau électronique pour former un plasma de gaz de traitement dans la chambre d'ionisation ;
iv) la focalisation par un champ magnétique et le balayage du plasma de gaz de traitement à l'aide d'un ou plusieurs électro-aimants pour former un faisceau de plasma.

10. Procédé selon la revendication 9, dans lequel le procédé implique en outre d'augmenter la densité du plasma de gaz inerte en utilisant un champ magnétique (par ex. généré par un solénoïde).

11. Procédé selon l'une ou l'autre des revendications 9 ou 10, dans lequel le procédé implique en outre d'améliorer la densité du plasma de gaz de traitement en utilisant un champ magnétique à plusieurs cuspides.

12. Procédé selon l'une quelconque des revendications 9 à 11, dans lequel à l'étape (ii) le faisceau électronique est en outre collimaté par une lentille électrostatique.

13. Procédé selon la revendication 9, dans lequel le gaz inerte est l'argon.

14. Procédé selon la revendication 9 ou 10, dans lequel le gaz de traitement est choisi parmi les gaz azote, oxygène et hydrocarbures.

15. Procédé de génération d'un faisceau de plasma selon l'une quelconque des revendications 9 à 14 en utilisant un appareil selon l'une quelconque des revendications 1 à 8.
